# EUROPÄISCHE PATENTSCHRIFT

(11) **EP 2 766 994 B1**
(45) Veröffentlichungstag und Bekanntmachung des Hinweises auf die Patenterteilung: **01.05.2019**
(21) Anmeldenummer: 12766994.3
(22) Anmeldetag: 04.10.2012
(51) Int. Cl.: H03K 17/96, B32B 17/10, F21V 23/04

(54) **SCHEIBE MIT BELEUCHTETER SCHALTFLÄCHE**
PANE WITH LIT BUTTON
DISQUE DOTÉ D'UN BOUTON DE COMMANDE ÉCLAIRÉ

(30) Priorität: 10.10.2011 EP 11184476
(43) Veröffentlichungstag der Anmeldung: 20.08.2014
(73) Patentinhaber: Saint-Gobain Glass France, 92400 Courbevoie (FR)
(72) Erfinder: REUL, Bernhard, 52134 Herzogenrath (DE); SCHMALBUCH, Klaus, 84220 Goult (FR)
(74) Vertreter: Gebauer, Dieter Edmund
(86) Internationale Anmeldenummer: PCT/EP2012/069558
(87) Internationale Veröffentlichungsnummer: WO 2013/053629

(56) Entgegenhaltungen:
- WO-A1-2008/022866
- WO-A1-2009/037131
- DE-A1-102006 022 965
- US-A1- 2003 210 537

## Beschreibung

Die Erfindung betrifft eine Scheibe mit beleuchteter Schaltfläche, ein Verfahren zu ihrer Herstellung und ihre Verwendung.

Es ist bekannt, dass Schaltflächen durch eine Flächenelektrode oder durch eine Anordnung von zwei gekoppelten Elektroden ausgebildet werden können, beispielsweise als kapazitive Schaltflächen. Nähert sich ein Objekt der Schaltfläche, so ändert sich die Kapazität der Flächenelektrode gegen Erde oder die Kapazität des von den zwei gekoppelten Elektroden gebildeten Kondensators. Die Kapazitätsänderung wird über eine Schaltungsanordnung gemessen und bei Überschreiten eines Schwellwerts wird ein Schaltsignal ausgelöst. Schaltungsanordnungen für kapazitive Schalter sind beispielsweise aus DE 20 2006 006 192 U1, EP 0 899 882 A1, US 6,452,514 B1 und EP 1 515 211 A1 bekannt. Die Elektrode oder die Elektroden können direkt auf einer Scheibe aus Glas oder einem anderen transparenten Material aufgebracht sein, was beispielsweise aus EP 1 544 178 A1 bekannt ist. Die Schaltfläche kann so ohne weitere Bauelemente in eine Verglasung integriert werden. Die Schaltfläche ist dabei allerdings nicht oder nur schwer zu erkennen. Bei Dunkelheit kann die Schaltfläche zudem nicht ertastet werden. Daher muss die Position der Schaltfläche markiert werden, wobei die Markierung insbesondere auch bei Dunkelheit wahrnehmbar sein muss. Leuchtelemente wie LEDs können beispielsweise um die Schaltfläche in die Verglasung integriert sein oder auf der Verglasung angebracht sein. Dadurch wird das optische Erscheinungsbild der Verglasung nachteilhaft beeinflusst. Zudem erschweren die Leuchtelemente als zusätzliche Bauteile innerhalb der Verglasung oder auf der Oberfläche der Verglasung die Herstellung und Wartung der Verglasung. Alternativ kann die Schaltfläche von einer externen Lichtquelle beleuchtet werden. Dabei ist eine aufwendige und fehleranfällige Justierung der externen Lichtquelle erforderlich. Außerdem kann die Beleuchtung der Schaltfläche leicht, beispielsweise durch einen Benutzer unterbrochen werden. Ein Beispiel für eine beleuchtete Schaltfläche, bei der das Licht seitlich in eine transparente Schicht eingestrahlt wird und an der Schaltfläche gestreut wird ist aus US2003/0210537 bekannt.

Die Aufgabe der vorliegenden Erfindung ist es, eine Scheibe mit integrierter Schaltfläche und ein Verfahren zu ihrer Herstellung bereitzustellen, wobei die Position der Schaltfläche ohne störende Bauelemente insbesondere bei Dunkelheit gekennzeichnet ist.

Die Aufgabe der vorliegenden Erfindung wird erfindungsgemäß durch eine Scheibe mit beleuchteter Schaltfläche gemäß dem unabhängigen Anspruch 1 gelöst. Bevorzugte Ausführungen gehen aus den Unteransprüchen hervor.

Die erfindungsgemäße Scheibe mit beleuchteter Schaltfläche umfasst die folgenden Merkmale:
- ein transparentes Substrat,
- eine elektrisch leitfähige Struktur, die eine Schaltfläche ausbildet,
- einen Flachleiter, der über ein elektrisches Verbindungselement mit der elektrisch leitfähigen Struktur elektrisch verbunden ist,
- ein Lichteinstrahlmittel, das zumindest eine Lichtquelle umfasst und auf dem Flachleiter und an einer Seitenkante des Substrats angeordnet ist, wobei Licht von der Seitenkante des Substrats in die Scheibe eingekoppelt wird,
- ein Lichtablenkmittel, das in dem vom Licht des Lichteinstrahlmittels bestrahlten Bereich der Scheibe angeordnet ist, wobei die Fläche, die aus einer Projektion des Lichtablenkmittels auf die Ebene der Schaltfläche hervorgeht, innerhalb der Schaltfläche angeordnet ist und / oder die Schaltfläche fortlaufend oder unterbrochen umrandet.

Das Licht des Lichteinstrahlmittels wird über die Seitenkante des Substrats in die erfindungsgemäße Scheibe eingekoppelt. Das Licht des Lichteinstrahlmittels tritt also über die Seitenkante des Substrats in die erfindungsgemäße Scheibe ein. Ein Bereich der Scheibe wird vom eingekoppelten Licht bestrahlt. Der vom Licht bestrahlte Bereich der Scheibe wird dabei durch die Abstrahlcharakteristik des Lichteinstrahlmittels bestimmt. Das Substrat weist typischerweise einen höheren Brechungsindex als die Umgebung der Scheibe auf. Das eingekoppelte Licht wird an den Oberflächen des Substrats nach dem Prinzip der Totalreflexion in das Innere des Substrats zurückgeworfen. Alternativ wird das eingekoppelte Licht an den vom Substrat abgewandten Oberflächen weiterer mit dem Substrat verbundener Schichten, die einen ähnlichen Brechungsindex wie das Substrat aufweisen, totalreflektiert und in das Innere der Scheibe zurückgeworfen. Licht, welches beim Durchlaufen der Scheibe auf das Lichtablenkmittel trifft, wird nicht totalreflektiert, sondern verlässt die Scheibe, bevorzugt durch Streuung am Lichtablenkmittel. Der Bereich des Lichtablenkmittels wird daher von einem Betrachter als leuchtende Fläche auf der Scheibe wahrgenommen.

Die leuchtende Fläche auf der Scheibe kennzeichnet erfindungsgemäß vorteilhaft die Position der Schaltfläche durch die Positionierung des Lichtablenkmittels relativ zur Schaltfläche. Durch die erfindungsgemäße Bauweise mit der Schaltfläche und dem Lichtablenkmittel, welche in die Scheibe integriert sind, und dem Lichteinstrahlmittel, welches an der Seitenkante des Substrats angeordnet ist, wird eine vorteilhaft geringe Dicke der Scheibe mit beleuchteter Schaltfläche erreicht. Die Dicke entspricht im Wesentlichen der Dicke des Substrats und eventuell mit dem Substrat verbundener weiterer Verglasungsschichten. Die Scheibe ist zudem einfach und kostengünstig herzustellen und die Schaltfläche, das Lichtablenkmittel und das Lichteinstrahlmittel sind dauerhaft stabil relativ zueinander angeordnet. Das sind große Vorteile der vorliegenden Erfindung.

Das Lichtablenkmittel und die Schaltfläche können in räumlich unterschiedlichen Ebenen angeordnet sein. Mit Ebene wird hierbei eine Fläche bezeichnet, die parallel zur Oberfläche der Scheibe ausgeformt ist. Das Lichtablenkmittel ist erfindungsgemäß so angeordnet, dass die Fläche, die aus der Projektion des Lichtablenkmittels auf die Ebene der Schaltfläche hervorgeht, innerhalb der Schaltfläche angeordnet ist und / oder die Schaltfläche fortlaufend oder unterbrochen umrandet. Hierbei wird eine orthogonale Projektion des Lichtablenkmittels durchgeführt, wobei die Projektionsebene diejenige Ebene ist, in der die Schaltfläche angeordnet ist. Die Projektionsebene kann auch von einer gekrümmten Fläche aufgespannt werden, insbesondere im Falle einer gekrümmten erfindungsgemäßen Scheibe.

Das Lichtablenkmittel umfasst bevorzugt Strukturen zur Lichtstreuung. Diese Strukturen sind besonders bevorzugt Partikel, Punktraster, Aufkleber, Anlagerungen, Einkerbungen, Einritzungen, Strichraster, Aufdrucke und / oder Siebdrucke. Das Lichtablenkmittel kann eine einzige zusammenhängende Fläche ausbilden. Alternativ kann das Lichtablenkmittel zwei oder mehrere voneinander getrennte Flächen ausbilden.

Das Lichtablenkmittel kann jede beliebige Form aufweisen, die dazu geeignet ist, die Position der Schaltfläche zu markieren. Das Lichtablenkmittel kann beispielsweise eine einfache zweidimensionale geometrische Form wie einen Kreis, eine Ellipse, ein Dreieck, ein Rechteck, ein Quadrat oder ein anders geartetes Viereck, ein höheres Polygon oder Kombinationen davon aufweisen. Die geometrische Figur kann dabei vollflächig mit dem Lichtablenkmittel ausgefüllt sein. Alternativ kann das Lichtablenkmittel entlang des Randes der geometrischen Figur umlaufend oder unterbrochen angeordnet sein. Das Lichtablenkmittel kann auch eine Form aufweisen, welche die über die Schaltfläche gesteuerte Funktion beschreibt, beispielsweise ein "Plus"- oder "Minus"-Zeichen, ein oder mehrere Buchstaben und / oder Zahlen oder ein Piktogramm. Das Lichtablenkmittel kann auch die Form eines anderen graphischen Symbols, beispielsweise eines Firmen- oder Markensymbols aufweisen. Das Lichtablenkmittel kann auch eine Form aufweisen, die sich aus einer Kombination der genannten Beispiele ergibt, beispielsweise einen umlaufenden Kreisrand um ein Piktogramm.

Der Flächeninhalt der Fläche, die aus einer Projektion des Lichtablenkmittels auf die Ebene der Schaltfläche hervorgeht, beträgt bevorzugt von 5 % bis 300 %, besonders bevorzugt von 10 % bis 200 % und ganz besonders bevorzugt von 20 % bis 150 % des Flächeninhalts der Schaltfläche. Das ist besonders vorteilhaft im Hinblick auf eine deutliche und eindeutige Kennzeichnung der Position der Schaltfläche auf der erfindungsgemäßen Scheibe durch am Lichtablenkmittel gestreutes Licht.

Die Fläche, die aus der Projektion des Lichtablenkmittels auf die Ebene der Schaltfläche hervorgeht, kann vollständig innerhalb der Schaltfläche angeordnet sein. Der Flächeninhalt der Fläche, die aus der Projektion des Lichtablenkmittels auf die Ebene der Schaltfläche hervorgeht, ist dabei bevorzugt kleiner als der Flächeninhalt der Schaltfläche. Dadurch wird die Position der Schaltfläche durch die leuchtende Fläche auf der Scheibe vorteilhaft gekennzeichnet, wobei auch eine Berührung der Scheibe in einem an die leuchtende Fläche grenzenden Bereich noch zum Auslösen eines Schaltvorgangs führt.

Alternativ kann der Flächeninhalt der Fläche, die aus der Projektion des Lichtablenkmittels auf die Ebene der Schaltfläche hervorgeht, gleich dem Flächeninhalt der Schaltfläche sein. Die Fläche, die aus der Projektion des Lichtablenkmittels auf die Ebene der Schaltfläche hervorgeht, und die Schaltfläche sind dabei bevorzugt identisch oder annähernd identisch. Dadurch wird die Position der Schaltfläche durch die leuchtende Fläche auf der Scheibe vorteilhaft gekennzeichnet. Eine Berührung der leuchtenden Fläche auf der Scheibe führt zum Auslösen eines Schaltvorgangs.

In einer alternativen vorteilhaften Ausgestaltung der Erfindung ist der Flächeninhalt der Fläche, die aus der Projektion des Lichtablenkmittels auf die Ebene der Schaltfläche hervorgeht, größer als der Flächeninhalt der Schaltfläche. Ein erster Bereich der Fläche, die aus der Projektion des Lichtablenkmittels auf die Ebene der Schaltfläche hervorgeht, überlappt dabei bevorzugt vollständig mit der Schaltfläche. Ein zweiter Bereich der Fläche, die aus der Projektion des Lichtablenkmittels auf die Ebene der Schaltfläche hervorgeht, umrandet die Schaltfläche. Da ein Benutzer zum Auslösen eines Schaltvorgangs intuitiv den inneren Bereich der leuchtenden Fläche auf der Scheibe berührt, wird die Position der Schaltfläche vorteilhaft gekennzeichnet.

In einer alternativen vorteilhaften Ausgestaltung der Erfindung wird die Schaltfläche von der Fläche, die aus der Projektion des Lichtablenkmittels auf die Ebene der Schaltfläche hervorgeht, umrandet. Die Umrandung kann fortlaufend oder unterbrochen ausgestaltet sein und beispielsweise eine Breite von 0,2 cm bis 2 cm, etwa 1 cm, aufweisen. Die Fläche, die aus der Projektion des Lichtablenkmittels auf die Ebene der Schaltfläche hervorgeht, und die Schaltfläche überlappen einander nicht oder nur im Randbereich der Schaltfläche. Da ein Benutzer zum Auslösen eines Schaltvorgangs intuitiv den von der leuchtenden Fläche umrandeten Bereich auf der Scheibe berührt, wird die Position der Schaltfläche vorteilhaft gekennzeichnet.

In einer alternativen vorteilhaften Ausgestaltung umfasst das Lichtablenkmittel einen ersten und einen zweiten Bereich, die nicht miteinander verbunden sind. Die Fläche, die aus der Projektion des ersten Bereichs des Lichtablenkmittels auf die Ebene der Schaltfläche hervorgeht, umrandet die Schaltfläche fortlaufend oder unterbrochen. Die Fläche, die aus der Projektion des zweiten Bereichs des Lichtablenkmittels auf die Ebene der Schaltfläche hervorgeht, ist vollständig innerhalb der Schaltfläche angeordnet. Der erste Bereich des Lichtablenkmittels kann beispielsweise als umlaufender Kreisrand ausgeformt sein. Der zweite Bereich des Lichtablenkmittels kann beispielsweise als Symbol oder Piktogramm ausgeformt sein. Dadurch wird die Position der Schaltfläche durch die leuchtende Fläche auf der Scheibe vorteilhaft gekennzeichnet.

Das Substrat enthält bevorzugt vorgespanntes, teilvorgespanntes oder nichtvorgespanntes Glas, besonders bevorzugt Flachglas, Floatglas, Quarzglas, Borosilikatglas, Kalk-Natron-Glas, oder klare Kunststoffe, insbesondere Polyethylen, Polypropylen, Polycarbonat, Polymethylmethacrylat, Polystyrol, Polyamid, Polyester, Polyvinylchlorid und / oder Gemische davon.

Die Dicke des Substrats kann breit variieren und so hervorragend den Erfordernissen des Einzelfalls angepasst werden. Das Substrat weist bevorzugt eine Dicke von 1 mm bis 10 mm und besonders bevorzugt von 2 mm bis 7 mm auf. Die Fläche des Substrats kann breit variieren, beispielsweise von 100 cm² bis 18 m². Bevorzugt weist das Substrat eine Fläche von 400 cm² bis 4 m² auf, wie sie für Verglasungen von Fahrzeugen und von Bau- und Architekturverglasungen üblich sind.

Das Substrat kann eine beliebige dreidimensionale Form aufweisen. Das Substrat ist bevorzugt plan oder leicht oder stark in einer Richtung oder in mehreren Richtungen des Raumes gebogen.

Die Schaltfläche ist bevorzugt eine kapazitive Schaltfläche. In einer vorteilhaften Ausgestaltung bildet die elektrisch leitfähige Struktur dabei eine Flächenelektrode aus. Über eine externe Steuerungselektronik wird die Kapazität der Flächenelektrode gemessen. Die Kapazität der Flächenelektrode ändert sich gegen Erde, wenn ein geerdeter Körper in ihre Nähe kommt oder beispielsweise eine Isolatorschicht über der Flächenelektrode berührt. Die Kapazitätsänderung wird durch die Steuerungselektronik gemessen und bei Überschreiten eines Schwellwerts wird ein Schaltsignal ausgelöst. Die Schaltfläche wird durch Form und Größe der Flächenelektrode festgelegt.

In einer alternativen vorteilhaften Ausgestaltung bildet die elektrisch leitfähige Struktur zwei Elektroden aus, die kapazitiv miteinander gekoppelt sind. Die Elektroden können beispielsweise spiralartige, kammartige oder mäanderartige Formen aufweisen. Die Kapazität des von den Elektroden gebildeten Kondensators ändert sich bei Annäherung eines Körpers. Die Kapazitätsänderung wird durch die Steuerungselektronik gemessen und bei Überschreiten eines Schwellwerts wird ein Schaltsignal ausgelöst. Die Schaltfläche wird durch Form und Größe des Bereichs, in denen die Elektroden kapazitiv gekoppelt sind, festgelegt.

Alternativ kann die Schaltfläche auch induktive, thermische oder sämtliche andere Sensorfunktionen aufweisen, die berührungslos sind. Berührungslos bedeutet dabei, dass keine direkte Berührung der elektrisch leitfähigen Struktur zum Auslösen eines Schaltvorgangs notwendig ist. Natürlich ist die Schaltfunktion auch bei direkter Berührung der elektrisch leitfähigen Struktur wirksam, falls die elektrisch leitfähige Struktur für den Benutzer zugänglich ist. Prinzipiell können auch Schaltflächen mit berührungsabhängigen Sensorfunktionen erfindungsgemäß gekennzeichnet werden.

Die Schaltfläche ist in die erfindungsgemäße Scheibe integriert. Es ist also kein Schalter als separates Bauteil nötig, welches an der Scheibe angebracht werden muss. Die erfindungsgemäße Scheibe, welche als Einzelscheibe oder als Verbundscheibe ausgebildet sein kann, weißt bevorzugt auch keine sonstigen Bauteile auf, die im Durchsichtbereich auf ihren Oberflächen angeordnet sind. Das ist besonders vorteilhaft im Hinblick auf eine dünne Bauweise der Scheibe sowie die Transparenz der Scheibe, insbesondere die Transparenz der Schaltfläche.

Die Schaltfläche weist bevorzugt eine Fläche von 1 cm² bis 200 cm², besonders bevorzugt von 1 cm² bis 10 cm² auf. Die Schaltfläche kann beispielsweise die Form eines Ovals, einer Ellipse oder eines Kreises, eines Dreiecks, eines Rechtecks, eines Quadrats oder eines anders gearteten Vierecks oder eines höheren Polygons aufweisen.

Die elektrisch leitfähige Struktur kann durch Aufdrucken und Einbrennen einer leitfähigen Paste hergestellt werden. Die leitfähige Paste enthält dabei bevorzugt Silber-Partikel und Glasfritten. Die Schichtdicke der eingebrannten Paste beträgt bevorzugt von 5 µm bis 40 µm, besonders bevorzugt von 8 µm bis 20 µm. Die eingebrannte Silberpaste weist selbst lichtstreuende Eigenschaft auf und kann daher vorteilhaft selbst als Lichtablenkmittel dienen.

Alternativ kann die elektrisch leitfähige Struktur durch Isolationsbereiche in einer elektrisch leitfähigen Beschichtung auf dem Substrat oder auf einer mit dem Substrat verbunden Schicht gebildet werden. Die elektrisch leitfähige Beschichtung enthält beispielsweise Silber, Zinkoxid, Indiumzinnoxid, Zinnoxid, Gallium, Gold, Kupfer, Wolfram und / oder Gemische davon. Die elektrisch leitfähige Beschichtung weist bevorzugt eine Schichtdicke von 5 nm bis 1 µm, besonders bevorzugt von 10 nm bis 500 nm auf. Die Isolationsbereiche können dabei beispielsweise durch Entfernung der Beschichtung durch Laserablation oder mechanische Abrasion oder durch den Isolationsbereich vollständig umlaufende elektrische Trennlinien gebildet werden. Zwei kapazitiv gekoppelte Elektroden weisen bevorzugt Leiterbahnen mit einer Breite von 5 µm bis 5 mm, besonders bevorzugt von 10 µm bis 2 mm auf. Die Isolationsbereiche weisen bevorzugt eine Breite von 5 µm bis 5 mm, besonders bevorzugt von 10 µm bis 2 mm auf. Damit werden besonders gute Ergebnisse erzielt.

Alternativ kann die elektrisch leitfähige Struktur durch bevorzugt sehr dünne und optisch kaum wahrnehmbare Drähte realisiert sein.

In einer vorteilhaften Ausgestaltung der Erfindung ist das Substrat ein Einscheiben-Sicherheitsglas. Die elektrisch leitfähige Struktur kann an der gleichen Oberfläche des Substrats wie das Lichtablenkmittel angeordnet sein. Dabei kann die elektrisch leitfähige Struktur aus der Richtung des Substrats über oder unter dem Lichtablenkmittel oder in der gleichen Ebene wie das Lichtablenkmittel angeordnet sein. Alternativ können die elektrisch leitfähige Struktur und das Lichtablenkmittel an den gegenüberliegenden Oberflächen des Substrats angeordnet sein.

Zwischen Substrat und elektrisch leitfähiger Struktur, zwischen Substrat und Lichtablenkmittel und / oder zwischen elektrisch leitfähiger Struktur und Lichtablenkmittel können weitere Schichten angeordnet sein. Auf der vom Substrat abgewandten Seite von elektrisch leitfähiger Struktur oder Lichtablenkmittel können weitere Schichten angeordnet sein, beispielsweise zum Schutz gegen Beschädigung. Die elektrisch leitfähige Struktur und / oder das Lichtablenkmittel können auch auf einer mit dem Substrat verbundenen Trägerfolie aufgebracht sein.

In einer weiteren vorteilhaften Ausgestaltung ist das Substrat Teil einer Verbundscheibe, insbesondere eines Verbundsicherheitsglases. Dabei ist das Substrat über mindestens eine Zwischenschicht mit zumindest einer Deckscheibe verbunden. Die Zwischenschicht enthält bevorzugt zumindest einen thermoplastischen Kunststoff, wie Polyvinylbutyral (PVB) oder Ethylenvinylacetat (EVA) oder mehrere Schichten davon, bevorzugt mit Dicken von 0,3 mm bis 0,9 mm. Damit werden besonders gute Ergebnisse erzielt.

Die Deckscheibe enthält bevorzugt vorgespanntes, teilvorgespanntes oder nichtvorgespanntes Glas, besonders bevorzugt Flachglas, Floatglas, Quarzglas, Borosilikatglas, Kalk-Natron-Glas, oder klare Kunststoffe, insbesondere Polyethylen, Polypropylen, Polycarbonat, Polymethylmethacrylat, Polystyrol, Polyamid, Polyester, Polyvinylchlorid und / oder Gemische davon. Die Deckscheibe weist bevorzugt eine Dicke von 1 mm bis 10 mm und besonders bevorzugt von 1,5 mm bis 7 mm auf.

Die elektrisch leitfähige Struktur kann auf einer Oberfläche des Substrats aufgebracht sein. Alternativ kann die elektrisch leitfähige Struktur auf der zum Substrat hingewandten oder auf der vom Substrat abgewandten Oberfläche der Deckscheibe aufgebracht sein.

Das Lichtablenkmittel kann auf einer Oberfläche des Substrats aufgebracht sein. Alternativ kann das Lichtablenkmittel auf der zum Substrat hingewandten oder auf der vom Substrat abgewandten Oberfläche der Deckscheibe aufgebracht sein.

Die elektrisch leitfähige Struktur und das Lichtablenkmittel sind bevorzugt an einer der zur Zwischenschicht hingewandten Flächen des Substrats und / oder der Deckscheibe angeordnet. Dadurch werden die elektrisch leitfähige Struktur und das Lichtablenkmittel vorteilhaft vor Beschädigungen geschützt.

Die elektrisch leitfähige Struktur und / oder das Lichtablenkmittel können auf einer Trägerfolie aufgebracht sein. Die Trägerfolie enthält bevorzugt zumindest ein Polyester und / oder ein Polyimid, besonders bevorzugt ein thermoplastisches Polyester, beispielsweise Polyethylennaphthalat (PEN) oder Polyethylenterephthalat (PET). Das ist besonders vorteilhaft im Hinblick auf die Stabilität und Verarbeitbarkeit der Trägerfolie. In einer besonders bevorzugten Ausgestaltung sind die elektrisch leitfähige Struktur und das Lichtablenkmittel auf der Trägerfolie aufgebracht. Der besondere Vorteil liegt in einer einfachen gemeinsamen Positionierung von elektrisch leitfähiger Struktur und Lichtablenkmittel bei der Herstellung des Verbund-Sicherheitsglases. Die Trägerfolie ist zwischen Substrat und Deckscheibe angeordnet. Die Trägerfolie mit dem Lichtablenkmittel und der elektrisch leitfähigen Struktur ist besonders bevorzugt über zumindest eine erste Zwischenschicht mit dem Substrat und über zumindest eine zweite Zwischenschicht mit der Deckscheibe verbunden. Die Dicke der Trägerfolie beträgt bevorzugt von 10 µm bis 1 mm, besonders bevorzugt von 30 µm bis 200 µm. In diesem Bereich der Dicke ist die Trägerfolie vorteilhaft stabil und gut zu verarbeiten. Die Länge und Breite der Trägerfolie kann gleich der Länge und Breite des Substrats sein. Die Länge und Breite der Trägerfolie kann auch kleiner als die Länge und Breite des Substrats sein.

Die erfindungsgemäße Scheibe weist bevorzugt einen transparenten Durchsichtbereich auf. Das bedeutet, dass ein Betrachter Objekte durch den Durchsichtbereich der Scheibe hindurch wahrnehmen kann. Die Schaltfläche sowie das Lichtablenkmittel sind bevorzugt im Durchsichtbereich der Scheibe angeordnet. Im Durchsichtbereich sind bevorzugt keine großflächigen opaken Bauteile angeordnet. Der Flachleiter ist bevorzugt vollständig außerhalb des Durchsichtbereichs der Scheibe angeordnet. Dadurch wird die Durchsicht durch die Scheibe nicht durch den Flachleiter gestört.

Das Lichteinstrahlmittel umfasst erfindungsgemäß zumindest eine Lichtquelle, bevorzugt eine LED oder OLED. Der besondere Vorteil liegt in den kleinen Abmessungen und der geringen Leistungsaufnahme. Der von der Lichtquelle emittierte Wellenlängenbereich kann im Bereich des sichtbaren Lichtes frei gewählt werden, beispielsweise nach praktischen und / oder ästhetischen Gesichtspunkten. Das Lichteinstrahlmittel kann optische Elemente umfassen, insbesondere zur Lenkung des Lichts, bevorzugt einen Reflektor und / oder einen Lichtwellenleiter, beispielsweise eine Glasfaser oder eine polymere optische Faser.

Das Lichteinstrahlmittel ist bevorzugt seitlich versetzt zum Substrat an der Seitenkante des Substrats angeordnet. Dadurch wird eine vorteilhaft platzsparende, dünne Bauweise der erfindungsgemäßen Scheibe erreicht. Der Abstand zwischen dem Lichteinstrahlmittel und der Seitenkante des Substrats beträgt bevorzugt kleiner oder gleich 10 mm, besonders bevorzugt kleiner oder gleich 5 mm, ganz besonders bevorzugt kleiner oder gleich 2 mm und insbesondere kleiner oder gleich 1 mm. Damit wird eine effiziente Einkopplung des Lichts des Lichteinstrahlmittels über die Seitenkante des Substrats in die Scheibe erreicht.

Das Lichteinstrahlmittel ist auf dem Flachleiter angeordnet und wird bevorzugt über den Flachleiter mit Spannung versorgt. Der besondere Vorteil liegt in einer platzsparenden Bauweise, da keine zusätzlichen Bauteile zur Befestigung des Lichteinstrahlmittels an der Scheibe und keine eigene Spannungsversorgung des Lichteinstrahlmittels notwendig sind.

Anteile des in die Scheibe eingekoppelten Lichts, die mit einem Einfallswinkel auf eine reflektierende Grenzfläche treffen, der kleiner ist als der Grenzwinkel der Totalreflexion, werden nicht vollständig in das Innere der Scheibe zurückgeworfen, sondern verlassen die Scheibe vorteilhaft im Randbereich in der Nähe des Lichteinstrahlmittels. Dadurch fallen die ausgekoppelten Anteile des Lichtes dem Betrachter nicht störend auf und können zudem einfach durch beispielsweise Absiebdrucke und / oder Rahmenelemente abgedeckt werden.

Der Flachleiter (auch Flachbandleiter oder Folienleiter genannt) kann neben zumindest einem elektrisch leitfähigen Kern eine elektrisch isolierende Ummantlung umfassen. Das Lichteinstrahlmittel ist dabei bevorzugt auf der Ummantelung angeordnet und die Lichtquelle ist elektrisch mit dem leitfähigen Kern verbunden. Das Lichteinstrahlmittel ist fest dauerhaft stabil mit dem Flachleiter verbunden. Das Lichteinstrahlmittel wird dadurch dauerhaft stabil an der vorgesehenen Position fixiert, wobei keine zusätzlichen Befestigungselemente nötig sind.

Der elektrisch leitfähige Kern des Flachleiters besteht bevorzugt aus einem Band eines Metalls oder einer Legierung, beispielsweise aus Kupfer, verzinntem Kupfer, Aluminium, Gold, Silber und / oder Zinn. Das Band weist bevorzugt eine Dicke von 0,3 mm bis 0,2 mm, beispielsweise 0,1 mm, und eine Breite von 2 mm bis 16 mm auf. Die isolierende Ummantelung enthält bevorzugt Kunststoff und besteht beispielsweise auf einer Kunststoff-Folie mit einer Dicke von 0,025 mm bis 0,05 mm.

Die elektrisch leitfähige Struktur ist erfindungsgemäß mit dem Flachleiter elektrisch verbunden. Über den Flachleiter wird die elektrisch leitfähige Struktur bevorzugt zumindest mit einer Spannungsversorgung und einer externen Steuerungselektronik verbunden. Die Steuerungselektronik ist auf den jeweiligen Einsatzzweck abgestimmt und kann beim Auslösen eines Schaltvorgangs, beispielsweise einen Mechanismus zum Öffnen oder Schließen einer Tür oder die Beheizung der Scheibe auslösen.

Die elektrische Verbindung zwischen Flachleiter und jeder durch die elektrisch leitfähige Struktur gebildeten Elektroden erfolgt erfindungsgemäß über ein elektrisches Verbindungselement. Das elektrische Verbindungselement verläuft vom Randbereich der Oberfläche, auf der die elektrisch leitfähige Struktur aufgebracht ist, bis zur durch die elektrisch leitfähige Struktur gebildeten Elektrode. Der Flachleiter ist im Randbereich der erfindungsgemäßen Scheibe mit dem elektrischen Verbindungselement verbunden, bevorzugt durch Löten, Klemmen oder mittels eines elektrisch leitfähigen Klebstoffs. Dadurch können auf einfache Weise und für den Benutzer kaum sichtbar die Kontakte aus der Scheibe heraus oder von der Scheibe weg geführt werden. Der Randbereich der Scheibe, in dem der Flachleiter mit dem elektrischen Verbindungselement kontaktiert ist, kann beispielsweise durch einen Rahmen, sonstige Befestigungselemente oder durch einen Abdecksiebdruck abgedeckt sein.

Der Randbereich der Scheibe, in dem der Flachleiter mit dem elektrischen Verbindungselement kontaktiert ist, weist bevorzugt eine Breite von kleiner oder gleich 10 cm auf, besonders bevorzugt von kleiner oder gleich 5 cm. Der Flachleiter verläuft vom Randbereich der Scheibe, in dem er mit dem elektrischen Verbindungselement kontaktiert ist, über die Seitenkante der Scheibe hinaus von der Scheibe weg, um mit einer externen Spannungsversorgung verbunden zu werden. Der Flachleiter überlappt die Oberfläche des Substrats also entlang einer Länge von bevorzugt höchstens 10 cm, besonders bevorzugt höchstens 5 cm, beispielsweise von 1 cm bis 5 cm oder von 2 cm bis 3 cm. Dadurch wird die Durchsicht durch die Scheibe vorteilhaft wenig durch den Flachleiter gestört.

Bildet die elektrisch leitfähige Struktur zwei miteinander gekoppelte Elektroden aus, so verläuft ein elektrisches Verbindungselement von jeder Elektrode zum Randbereich der Oberfläche, auf der die elektrisch leitfähige Struktur aufgebracht ist. Der Flachleiter umfasst in diesem Fall bevorzugt zwei voneinander getrennte elektrisch leitfähige Kerne, die in einer gemeinsamen elektrisch isolierenden Ummantelung eingefasst sind. Die beiden elektrischen Verbindungselemente werden mit jeweils einem elektrisch leitfähigen Kern des Flachleiters verbunden. Alternativ können zwei Flachleiter zur Kontaktierung der beiden elektrischen Verbindungselemente verwendet werden.

Das elektrische Verbindungselement ist bevorzugt durch eine aufgedruckte und eingebrannte leitfähigen Paste, durch dünne Drähte oder durch Isolationsbereiche in einer elektrisch leitfähigen Beschichtung realisiert. Besonders bevorzugt ist das elektrische Verbindungselement von der gleichen Art wie die elektrisch leitfähige Struktur und wird zusammen mit der elektrisch leitfähigen Struktur aufgebracht.

In einer bevorzugten Ausgestaltung der Erfindung ist der Bereich des Flachleiters, auf dem das Lichteinstrahlmittel angebracht ist, parallel oder annähernd parallel zur Oberfläche des Substrats angeordnet. Dabei wird der Flachleiter gerade und ohne Verwindungen oder Verbiegungen von der erfindungsgemäßen Scheibe weggeführt. Der besondere Vorteil liegt in einer stabilen Positionierung des Lichteinstrahlmittels und einer Vermeidung von Beschädigungen des Flachleiters.

In einer alternativen bevorzugten Ausgestaltung der Erfindung ist der Bereich des Flachleiters, auf dem das Lichteinstrahlmittel angebracht ist, senkrecht oder annähernd senkrecht zur Oberfläche des Substrats angeordnet. Dabei wird der Flachleiter bevorzugt gebogen oder geknickt. Das ist besonders vorteilhaft im Hinblick auf eine effiziente Einkopplung des Lichts in die Scheibe, weil die vom Flachleiter abgewandte Oberseite der Lichtquelle, über welche typischerweise Licht abgestrahlt wird, auf die Seitenkante des Substrats gerichtet ist. Die Fixierung des Lichteinstrahlmittels an der Seitenkante des Substrats kann beispielsweise mittels eines transparenten Klebstoffes oder doppelseitigen Klebebandes erfolgen. Alternativ kann der Bereich des Flachleiters, auf dem das Lichteinstrahlmittel angebracht ist, mittels eines weiteren baulichen Elementes, beispielsweise eines Rahmens um das Substrat oder sonstiger Befestigungsmittel, an der vorgesehenen Position fixiert werden.

In einer vorteilhaften Ausgestaltung der Erfindung sind mehrere Lichtquellen, bevorzugt LEDs entlang der Hauptachse des Flachleiters angeordnet. Im Bereich der Lichtquellen wird der Flachleiter entlang der Seitenkante des Substrats geführt, wobei das Licht der Lichtquellen über die Seitenkante des Substrats in die Scheibe eingekoppelt wird. Der besondere Vorteil liegt in einer Vergrößerung des vom Licht bestrahlten Bereichs der Scheibe im Vergleich zur Ausgestaltung mit einer einzelnen Lichtquelle. Dadurch können vorteilhaft großflächigere Lichtablenkmittel mit Licht bestrahlt werden. Großflächige Lichtablenkmittel können beispielsweise zur Kennzeichnung von großflächigen Schaltflächen auftreten oder zur Kennzeichnung eines mehrere Schaltflächen umfassenden Schaltfeldes.

Alternativ kann das Lichteinstrahlmittel eine Lichtquelle und einen Lichtwellenleiter umfassen, wobei der Flachleiter im Bereich des Lichtwellenleiters entlang der Seitenkante des Substrats geführt wird und das Licht der Lichtquelle in den Lichtwellenleiter eingekoppelt wird. Dadurch können vorteilhaft großflächigere Lichtablenkmittel mit Licht bestrahlt werden.

Die Aufgabe der Erfindung wird weiter durch ein Verfahren zur Herstellung einer Scheibe mit beleuchteter Schaltfläche gelöst, wobei zumindest
(a) eine elektrisch leitfähige Struktur, die eine Schaltfläche ausbildet, ein mit der elektrisch leitfähigen Struktur verbundenes elektrisches Verbindungselement und ein Lichtablenkmittel auf ein transparentes Substrat aufgebracht werden, und
(b) ein Lichteinstrahlmittel auf einem Flachleiter angeordnet wird und der Flachleiter mit dem elektrischen Verbindungselement elektrisch verbunden wird, wobei das Lichteinstrahlmittel an einer Seitenkante des Substrats angeordnet wird.

In Verfahrensschritt (a) werden die elektrisch leitfähige Struktur und das elektrische Verbindungselement auf der gleichen Oberfläche des Substrats aufgebracht. Das Lichtablenkmittel kann an der gleichen Oberfläche des Substrats wie die elektrisch leitfähige Struktur und das elektrische Verbindungselement oder an der gegenüberliegenden Oberfläche des Substrats aufgebracht werden. Die elektrisch leitfähige Struktur und das elektrische Verbindungselement können zeitlich vor oder nach dem Lichtablenkmittel aufgebracht werden.

In Verfahrensschritt (b) kann die Anordnung des Lichteinstrahlmittels auf dem Flachleiter zeitlich vor oder nach dem elektrischen Verbinden von Flachleiter und elektrischem Verbindungselement erfolgen.

Durch eine geeignete Positionierung des elektrischen Verbindungselements wird das Lichteinstrahlmittel auf dem Flachleiter so an der Seitenkante des Substrats positioniert, dass das Lichtablenkmittel in dem vom Licht des Lichteinstrahlmittels bestrahlten Bereich der Scheibe angeordnet ist. Eine aufwendige Justierung der Position des Lichteinstrahlmittels ist nicht erforderlich. Das ist ein besonderer Vorteil des erfindungsgemäßen Verfahrens.

In einer alternativen Ausführung können zunächst die elektrisch leitfähige Struktur und das elektrische Verbindungselement aufgebracht und mit dem Flachleiter elektrisch verbunden werden und anschließend das Lichtablenkmittel aufgebracht werden.

Die Aufgabe der Erfindung wird weiter durch ein Verfahren zur Herstellung einer Scheibe mit beleuchteter Schaltfläche gelöst, wobei zumindest
(a) eine elektrisch leitfähige Struktur, die eine Schaltfläche ausbildet, und ein mit der elektrisch leitfähigen Struktur verbundenes elektrisches Verbindungselement auf ein transparentes Substrat oder auf eine Deckscheibe aufgebracht werden und ein Lichtablenkmittel auf das transparente Substrat oder auf die Deckscheibe aufgebracht wird,
(b) ein Lichteinstrahlmittel auf einem Flachleiter angeordnet wird und der Flachleiter mit dem elektrischen Verbindungselement elektrisch verbunden wird und
(c) das Substrat mit der Deckscheibe über mindestens eine Zwischenschicht unter Einwirkung von Hitze, Vakuum und / oder Druck verbunden wird, wobei das Lichteinstrahlmittel an einer Seitenkante des Substrats angeordnet wird.

In Verfahrensschritt (a) kann die elektrisch leitfähige Struktur auf der Deckscheibe und das Lichtablenkmittel auf dem Substrat aufgebracht werden. Alternativ kann die elektrisch leitfähige Struktur auf dem Substrat und das Lichtablenkmittel auf der Deckscheibe aufgebracht werden. Alternativ können die elektrisch leitfähige Struktur und das Lichtablenkmittel auf der Deckscheibe aufgebracht werden. Alternativ können die elektrisch leitfähige Struktur und das Lichtablenkmittel auf dem Substrat aufgebracht werden. Das elektrische Verbindungselement wird an der gleichen Oberfläche wie die elektrisch leitfähige Struktur aufgebracht.

In Verfahrensschritt (b) kann die Anordnung des Lichteinstrahlmittels auf dem Flachleiter zeitlich vor oder nach dem elektrischen Verbinden von Flachleiter und elektrischem Verbindungselement erfolgen.

In einer alternativen Ausführung kann das Anordnen des Lichteinstrahlmittels auf dem Flachleiter zeitlich nach dem Verbinden des Substrats, der Zwischenschicht und der Deckscheibe erfolgen.

Die Aufgabe der Erfindung wird weiter durch ein Verfahren zur Herstellung einer Scheibe mit beleuchteter Schaltfläche gelöst, wobei zumindest
(a) eine elektrisch leitfähige Struktur, die eine Schaltfläche ausbildet, ein mit der elektrisch leitfähigen Struktur verbundenes elektrisches Verbindungselement und ein Lichtablenkmittel auf eine Trägerfolie aufgebracht werden,
(b) ein Lichteinstrahlmittel auf einem Flachleiter angeordnet wird und der Flachleiter mit dem elektrischen Verbindungselement elektrisch verbunden wird und
(c) die Trägerfolie über eine erste Zwischenschicht mit einem Substrat und über eine zweite Zwischenschicht mit einer Deckscheibe unter Einwirkung von Hitze, Vakuum und / oder Druck verbunden wird, wobei das Lichteinstrahlmittel an einer Seitenkante des Substrats abgeordnet wird.

In einer alternativen Ausführung kann das Anordnen des Lichteinstrahlmittels auf dem Flachleiter zeitlich nach dem Verbinden des Substrats, der Zwischenschichten und der Deckscheiben erfolgen.

Bei den erfindungsgemäßen Verfahren ist die Positionierung der elektrisch leitfähigen Struktur und des Lichtablenkmittels so zu wählen, dass die Fläche, die aus der Projektion des Lichtablenkmittels auf die Ebene der Schaltfläche hervorgeht, innerhalb der Schaltfläche angeordnet ist und / oder die Schaltfläche fortlaufend oder unterbrochen umrandet. Das Lichteinstrahlmittel ist so an der Seitenkante des Substrats zu positionieren, dass der vom Licht des Lichteinstrahlmittels bestrahlte Bereich der Scheibe das Lichtablenkmittel umfasst.

Die Erfindung umfasst außerdem die Verwendung der Scheibe mit beleuchteter Schaltfläche als funktionales und / oder dekoratives Einzelstück und / oder als Einbauteil in Möbeln und Geräten, insbesondere elektronischen Geräten mit Kühl- oder Heizfunktion, zur Verglasung von Gebäuden, insbesondere im Zugangs- oder Fensterbereich, oder zur Verglasung in einem Fahrzeug für den Verkehr auf dem Lande, in der Luft oder zu Wasser, insbesondere in Kraftfahrzeugen, Bussen, Straßenbahnen, U-Bahnen und Zügen zur Personenbeförderung und für den öffentlichen Nah- und Fernverkehr, beispielsweise als Fahrzeugtür oder in einer Fahrzeugtür.

Die Erfindung wird anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein. Es zeigen:
- Fig. 1: eine Draufsicht auf eine erste Ausgestaltung der erfindungsgemäßen Scheibe mit beleuchteter Schaltfläche,
- Fig. 2: eine Draufsicht auf eine weitere Ausgestaltung der erfindungsgemäßen Scheibe mit beleuchteter Schaltfläche,
- Fig. 3: einen Schnitt A-A' durch die Scheibe gemäß Figur 1,
- Fig. 4: einen Schnitt A-A' durch eine weitere Ausgestaltung der erfindungsgemäßen Scheibe,
- Fig. 5: einen Schnitt A-A' durch eine weitere Ausgestaltung der erfindungsgemäßen Scheibe,
- Fig. 6: einen Schnitt A-A' durch eine weitere Ausgestaltung der erfindungsgemäßen Scheibe,
- Fig. 7: einen Schnitt A-A' durch eine weitere Ausgestaltung der erfindungsgemäßen Scheibe,
- Fig. 8: eine Draufsicht auf eine weitere Ausgestaltung der erfindungsgemäßen Scheibe,
- Fig. 9: ein Ausführungsbeispiel des erfindungsgemäßen Verfahrens anhand eines Flussdiagramms,
- Fig. 10: ein weiteres Ausführungsbeispiel des erfindungsgemäßen Verfahrens anhand eines Flussdiagramms,
- Fig. 11: ein weiteres Ausführungsbeispiel des erfindungsgemäßen Verfahrens anhand eines Flussdiagramms.

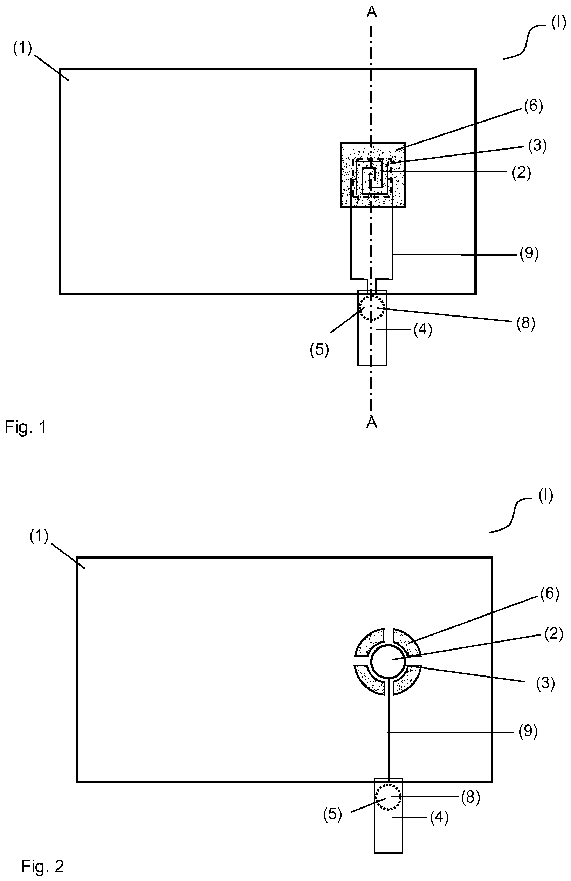

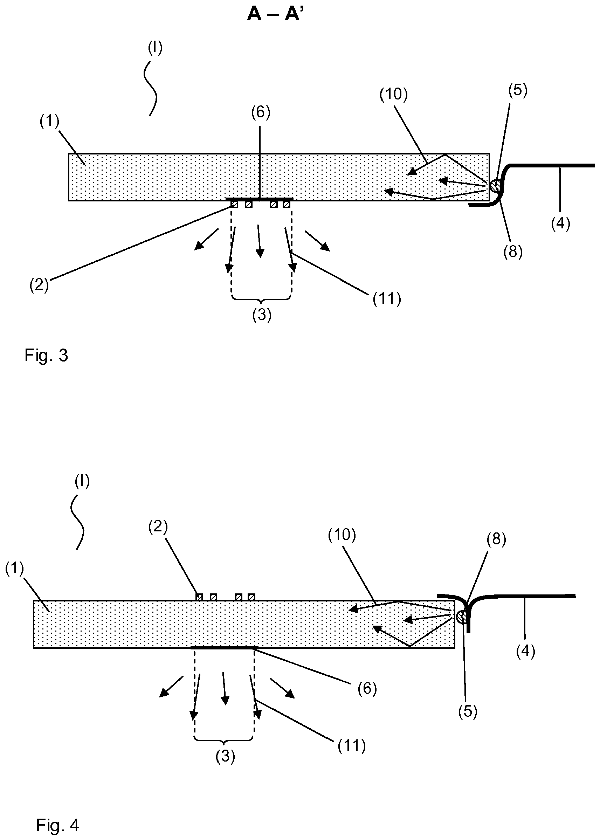

Fig. 1 und Fig. 3 zeigen je ein Detail einer erfindungsgemäßen Scheibe (I) mit beleuchteter Schaltfläche. Das Substrat 1 ist ein thermisch vorgespanntes Einscheiben-Sicherheitsglas aus Natron-Kalk-Glas. Das Substrat 1 weist eine Höhe von 1 m, eine Breite von 2,5 m und eine Dicke von 5 mm auf.

Auf einer Oberfläche des Substrats 1 ist ein Lichtablenkmittel 6 aufgebracht. Das Lichtablenkmittel 6 ist als aufgeraute Einkerbung ausgestaltet und als vollständig gefülltes Quadrat mit einer Kantenlänge von 6 cm ausgeformt.

Auf dem Lichtablenkmittel 6 ist eine elektrisch leitfähige Struktur 2 angeordnet. Die elektrisch leitfähige Struktur 2 ist ein Silberdruck mit einer Dicke von 10 µm, welcher zwei voneinander getrennte Elektroden mit einer Breite von 1 mm ausbildet. Die Elektroden sind mäanderartig mit einem Abstand von 1 mm umeinander angeordnet und kapazitiv miteinander gekoppelt.

Ein elektrisches Verbindungselement 9 verläuft von jeder der beiden durch die elektrisch leitfähige Struktur 2 gebildeten Elektroden zur unteren Seitenkante des Substrats 1. Die elektrischen Verbindungselemente 9 sind im Randbereich des Substrats 1 mit einem Flachleiter 4 verlötet. Der Flachleiter 4 umfasst zwei voneinander getrennte elektrisch leitfähige Kerne in einer gemeinsamen elektrisch isolierenden Ummantelung. Die beiden elektrischen Verbindungselemente 9 sind mit jeweils einem elektrisch leitfähigen Kern des Flachleiters 4 verbunden. Über den Flachleiter 4 und die elektrischen Verbindungselemente 9 ist die elektrisch leitfähige Struktur 2 mit einer nicht dargestellten externe Spannungsversorgung und Steuerungselektronik verbunden. Nähert sich ein Körper, beispielsweise ein menschlicher Finger der elektrisch leitfähigen Struktur 2, so ändert sich die Kapazität des durch die elektrisch leitfähige Struktur 2 gebildeten Kondensators. Die Steuerungselektronik kann die Kapazitätsänderung messen und bei Überschreitung eines Schwellwertes ein Schaltsignal auslösen. Die elektrisch leitfähige Struktur 2 bildet so eine Schaltfläche 3 aus. Die Schaltfläche 3 ist entsprechend der Anordnung der elektrisch leitfähigen Struktur 2 etwa quadratisch mit einer Kantenlänge von 5 cm ausgeformt.

Die quadratische Fläche, die aus der Projektion des Lichtablenkmittels 6 auf die Ebene der Schaltfläche 3 hervorgeht, und die quadratische Schaltfläche 3 haben denselben Mittelpunkt. Die Fläche, die aus der Projektion eines inneren quadratischen Bereichs des Lichtablenkmittels 6 mit einer Kantenlänge von 5 cm auf die Ebene des Schaltfläche 3 hervorgeht, ist innerhalb der Schaltfläche 3 angeordnet und füllt diese komplett aus. Die Fläche, die aus der Projektion des Randbereichs des Lichtablenkmittels 6 auf die Ebene der Schaltfläche 3 hervorgeht, umrandet die Schaltfläche 3 fortlaufend mit einer Breite von 0,5 cm.

In einer alternativen Ausgestaltung kann das Lichtablenkmittel 6 den gleichen Flächeninhalt wie die Schaltfläche 3 oder einen kleineren Flächeninhalt als die Schaltfläche 3 aufweisen. Beispielsweise kann das Lichtablenkmittel 6 als Quadrat mit einer Kantenlänge von 5 cm oder mit einer Kantenlänge von 4 cm ausgeformt sein. Dabei ist die Fläche, die aus der Projektion des Lichtablenkmittels 6 auf die Ebene der Schaltfläche 3 hervorgeht, vollständig innerhalb der Schaltfläche 3 angeordnet.

Auf der zum Substrat 1 hingewandten Seite des Flachleiters 4 ist ein Lichteinstrahlmittel 5 angeordnet. Das Lichteinstrahlmittel 5 umfasst eine LED als Lichtquelle 8. Der Flachleiter 4 ist so gebogen, dass der Bereich des Flachleiters 4, auf dem die Lichtquelle 8 angebracht ist, etwa senkrecht zur Oberfläche des Substrats 1 angeordnet ist. Der Flachleiter 4 mit der Lichtquelle 8 kann in der dargestellten Position beispielsweise durch einen transparenten Klebstoff oder durch einen Rahmen um die Scheibe (I) fixiert werden. Dadurch wird das Licht 10 der Lichtquelle 8 effizient über die Seitenkante des Substrats 1 in das Substrat 1 eingekoppelt. Das eingekoppelte Licht 10 wird von den inneren Oberflächen des Substrats 1 nach dem Prinzip der Totalreflexion in das Innere des Substrats 1 zurückgeworfen. Licht 10, das auf das Lichtablenkmittel 6 trifft, wird am Lichtablenkmittel 6 gestreut und verlässt das Substrat 1. Durch das gestreute Licht 11 erscheint der Bereich des Lichtablenkmittels 6 einem Betrachter als beleuchtete Fläche, welche die Position der Schaltfläche 3 markiert.

In einer alternativen Ausgestaltung der Erfindung kann das Lichtablenkmittel 6, beispielsweise in Form eines Aufklebers, auf der vom Substrat 1 abgewandten Oberfläche der elektrisch leitfähigen Struktur 2 angeordnet sein.

Fig. 2 zeigt eine Draufsicht auf eine alternative Ausgestaltung der erfindungsgemäßen Scheibe (I). Die elektrisch leitfähige Struktur 2 bildet eine Flächenelektrode, welche kreisförmig mit einem Radius von 4 cm ausgeformt ist. Die elektrisch leitfähige Struktur 2 ist über ein elektrisches Verbindungselement 9 mit dem Flachleiter 4 elektrisch verbunden. Eine externe Steuerungselektronik, die mit dem Flachleiter 4 verbunden ist, kann eine Kapazitätsänderung der Flächenelektrode gegen Erde messen, die beispielsweise durch die Annäherung eines Fingers hervorgerufen wird.

Das Lichtablenkmittel 6 ist als unterbrochener Kreisrand ausgeformt. Der Kreisrand weist einen maximalen Radius von 5 cm und eine Breite von 1 cm auf. Die Fläche, die aus der Projektion des Lichtablenkmittels 6 auf die Ebene der Schaltfläche 3 hervorgeht, umrandet die durch die elektrisch leitfähige Struktur 2 gebildete Schaltfläche 3. Am Lichtablenkmittel 6 gestreutes Licht 11 erscheint dem Betrachter als unterbrochener leuchtender Kreis, wobei zur Auslösung eines Schaltvorgangs beispielsweise ein Finger an den von dem leuchtenden Kreis begrenzten Bereich des Substrats 1 angenähert werden muss. Die Schaltfläche 3 wird somit durch das Lichtablenkmittel 6 gekennzeichnet.

Fig. 3 zeigt einen Schnitt entlang A-A' durch die erfindungsgemäße Scheibe (I) gemäß Figur 1.

Fig. 4 zeigt einen Schnitt A-A' durch eine alternative Ausgestaltung der erfindungsgemäßen Scheibe (I). Die elektrisch leitfähige Struktur 2 und das Lichtablenkmittel 6 sind auf gegenüberliegenden Seiten des Substrats 1 angeordnet. Der Flachleiter 4 ist geknickt, so dass der Bereich des Flachleiters 4, auf dem die Lichtquelle 8 angebracht ist, etwa senkrecht zur Oberfläche des Substrats 1 angeordnet ist. Dadurch wird das Licht 10 der Lichtquelle 8 effizient über die Seitenkante des Substrats 1 in das Substrat 1 eingekoppelt.

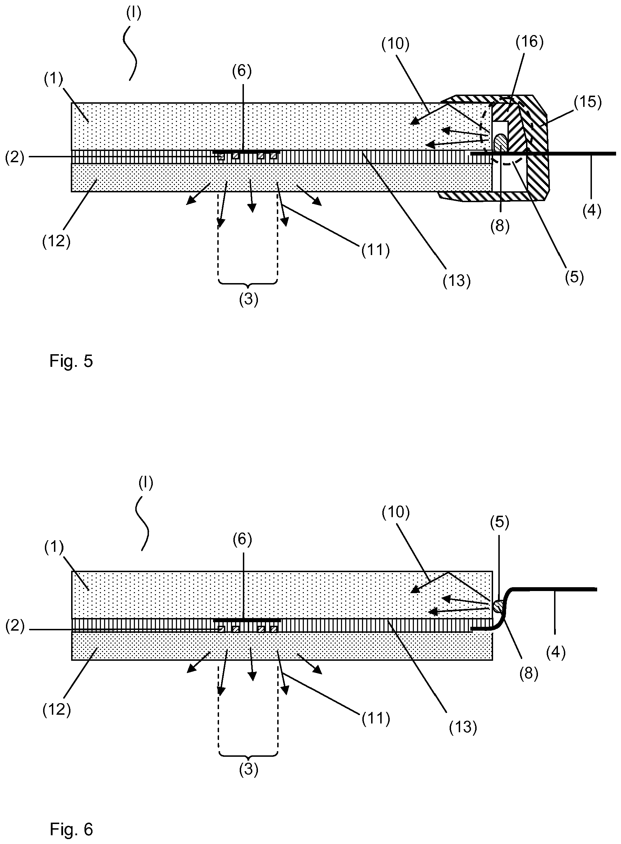

Fig. 5 zeigt einen Schnitt A-A' durch eine weitere alternative Ausgestaltung der erfindungsgemäßen Scheibe (I). Das Substrat 1 ist ein 3 mm dickes Kalk-Natron-Glas und weist eine Höhe von 1 m und eine Breite von 2,5 m auf. Die elektrisch leitfähige Struktur 2, das elektrische Verbindungselement 9 und das Lichtablenkmittel 6 sind gemäß der Figur 3 ausgeformt und auf dem Substrat 1 angeordnet. Das Substrat 1 ist über eine 0,76 mm dicke thermoplastische Zwischenschicht 13 mit einer Deckscheibe 12 zu einem Verbund-Sicherheitsglas verbunden. Die Verbindung des Substrats 1 mit der Deckscheibe 12 erfolgt über die Oberfläche des Substrats 1, an der die elektrisch leitfähige Struktur 2 und das Lichtablenkmittel 6 angeordnet sind. Dadurch werden die elektrisch leitfähige Struktur 2, das elektrische Verbindungselement 9 und das Lichtablenkmittel 6 vorteilhaft vor Beschädigungen, beispielsweise durch mechanischen Abrieb bei Berührung oder Korrosion, geschützt. Die Zwischenschicht 13 enthält Polyvinylbutyral (PVB). Die Deckscheibe 12 ist ein 2,1 mm dickes Kalk-Natron-Glas.

Das Lichteinstrahlmittel 5 umfasst eine LED als Lichtquelle 8 und einen Reflektor 16. Der Bereich des Flachleiters 4, auf dem das Lichteinstrahlmittel 5 angeordnet ist, ist etwa parallel zur Oberfläche des Substrats angeordnet. Dadurch kann der Flachleiter 4 ohne Verbiegungen oder Verknickungen von der Scheibe (I) weggeführt werden. Das ist besonders vorteilhaft im Hinblick auf die Vermeidung von Beschädigungen des Flachleiters 4. Durch den Reflektor 16 wird das Licht 10 der Lichtquelle 8 effizient über die Seitenkante des Substrats 1 in die Scheibe (I) eingekoppelt.

Der Randbereich von Substrat 1 und Deckscheibe 12 und das Lichteinstrahlmittel 5 sind von einem Rahmenelement 15 eingefasst. Das Rahmenelement 15 im Bereich des Lichteinstrahlmittels 5 ist bevorzugt vom übrigen Rahmen um die Scheibe (I) getrennt und unabhängig abnehmbar. Das ist besonders vorteilhaft im Hinblick auf eine einfache Anbringung und Wartung des Lichteinstrahlmittels. Lichtquelle 8 und / oder Reflektor 16 können bei einer Beschädigung einfach ausgetauscht werden.

Fig. 6 zeigt einen Schnitt A-A' durch eine weitere alternative Ausgestaltung der erfindungsgemäßen Scheibe (I). Das Substrat 1 ist über die Zwischenschicht 13 mit der Deckscheibe 12 zu einem Verbund-Sicherheitsglas verbunden. Das Lichtablenkmittel 6 ist auf der zur Deckscheibe 12 hingewandten Oberfläche des Substrats 1 angeordnet. Die elektrisch leitfähige Struktur 2 und das in dem Schnitt nicht auftretende elektrische Verbindungselement 9 sind auf der zum Substrat 1 hingewandten Oberfläche der Deckscheibe 12 angeordnet. Das Lichtablenkmittel 6, die elektrisch leitfähige Struktur 2 und das elektrische Verbindungselement 9 sind somit vorteilhaft vor Beschädigungen durch äußere Einflüsse geschützt.

In einer alternativen Ausgestaltung können die elektrisch leitfähige Struktur 2 und das elektrische Verbindungselement 9 an der vom Substrat 1 abgewandten Oberfläche der Deckscheibe 12 angeordnet sein.

In einer weiteren alternativen Ausgestaltung kann das Lichtablenkmittel 6 an der Deckscheibe 12 angeordnet sein. Das Substrat 1 und die Deckscheibe 12 weisen einen Brechungsindex von etwa 1,55 auf. Die PVB enthaltende Zwischenschicht 13 weist einen Brechungsindex von etwa 1,49 auf. Aufgrund des geringen Unterschieds der Brechungsindizes von Substrat 1, Zwischenschicht 13 und Deckscheibe 12 wird das eingekoppelte Licht 10 an den Grenzflächen innerhalb der Scheibe (I) nicht totalreflektiert und bestrahlt daher das Substrat 1, die Zwischenschicht 13 und die Deckscheibe 12.

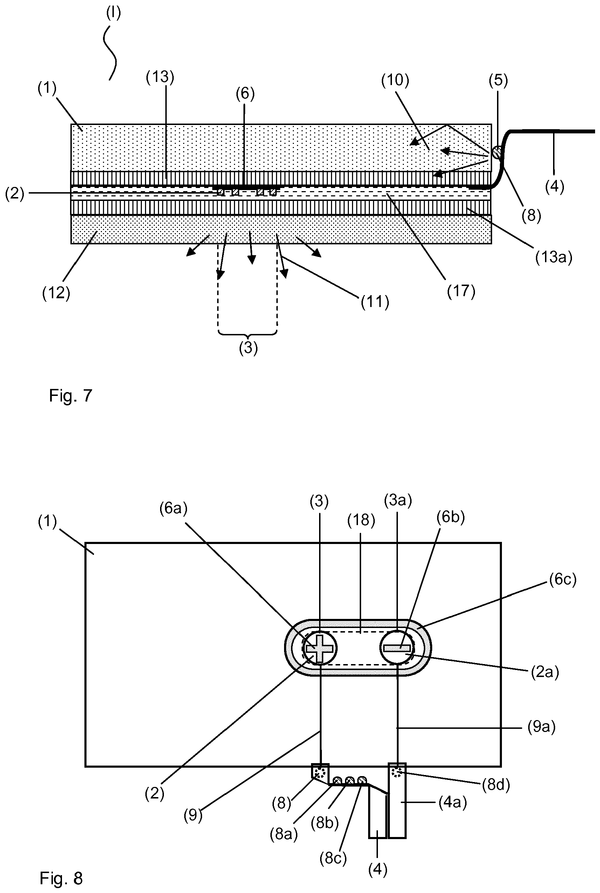

Fig. 7 zeigt einen Schnitt A-A' durch eine weitere alternative Ausgestaltung der erfindungsgemäßen Scheibe (I). Die elektrisch leitfähige Struktur 2, das in dem Schnitt nicht auftretende elektrische Verbindungselement 9 und das Lichtablenkmittel 6 sind auf einer Trägerfolie 17 angeordnet. Die Trägerfolie 17 enthält Polyethylenterephthalat (PET) und weist eine Dicke von 0,2 mm auf. Die Trägerfolie 17 ist zwischen einer ersten Zwischenschicht 13 und einer zweiten Zwischenschicht 13a angeordnet. Das Substrat 1 ist über die erste Zwischenschicht 13, die Trägerfolie 17 und die zweite Zwischenschicht 13a mit der Deckscheibe 12 verbunden. Die elektrisch leitfähige Struktur 2, das elektrische Verbindungselement 9 und das Lichtablenkmittel 6 können bei der Herstellung des Verbundglases durch die Trägerfolie 17 einfach gemeinsam an der für die Schaltfläche 3 vorgesehenen Stelle positioniert werden.

Fig. 8 zeigt eine Draufsicht auf eine weitere alternative Ausgestaltung der erfindungsgemäßen Scheibe (I). Auf dem Substrat 1 sind zwei elektrisch leitfähige Strukturen 2 und 2a aufgebracht. Die beiden elektrisch leitfähigen Strukturen 2, 2a sind dabei an der gleichen Oberfläche des Substrats 1 aufgebracht. Jede elektrisch leitfähige Struktur 2, 2a bildet eine Flächenelektrode und ist über ein Verbindungselement 9, 9a mit einem Flachleiter 4, 4a elektrisch verbunden.

Durch jede elektrisch leitfähige Struktur 2, 2a wird eine Schaltfläche 3, 3a ausgebildet. Die beiden Schaltflächen 3, 3a sind dafür vorgesehen, bei Annäherung eines Körpers zueinander komplementäre Funktionen auszulösen. Beispielsweise kann über die Schaltflächen 3, 3a die Transparenz einer elektrochromen Beschichtung gesteuert werden, wobei die Berührung der Schaltfläche 3 eine Verminderung der Transparenz und die Berührung der Schaltfläche 3a eine Erhöhung der Transparenz hervorruft. Aufgrund der komplementären Funktionen sollen die beiden Schaltflächen 3, 3a und der zwischen ihnen liegende Bereich der Scheibe (I) als Schaltfeld 18 gekennzeichnet werden.

Das Lichtablenkmittel 6 umfasst drei voneinander getrennte Bereiche 6a, 6b und 6c. Der Bereich 6a des Lichtablenkmittels 6 ist als "Plus"-Zeichen ausgeformt. Die Fläche, die aus der Projektion des Bereichs 6a des Lichtablenkmittels 6 auf die Ebene der Schaltflächen 3, 3a hervorgeht, ist vollständig innerhalb der Schaltfläche 3 angeordnet. Der Bereich 6b des Lichtablenkmittels 6 ist als "Minus"-Zeichen ausgeformt. Die Fläche, die aus der Projektion des Bereichs 6b des Lichtablenkmittels 6 auf die Ebene der Schaltflächen 3, 3a hervorgeht, ist vollständig innerhalb der Schaltfläche 3a angeordnet. Der Bereich 6c des Lichtablenkmittels 6 ist als nicht ausgefülltes Rechteck mit zwei an gegenüberliegenden Seiten angeordneten Halbkreisen ausgeformt. Die Fläche, die aus der Projektion des Bereichs 6c des Lichtablenkmittels 6 auf die Ebene der Schaltflächen 3, 3a hervorgeht, umrandet das Schaltfeld 18 fortlaufend.

Auf dem Flachleiter 4a ist eine LED als Lichtquelle 8d angeordnet. Auf dem Flachleiter 4 sind hintereinander vier LEDs als Lichtquellen 8, 8a, 8b, 8c angeordnet. Im Bereich der Lichtquellen 8a, 8b und 8c wird der Flachleiter 4 an der Seitenkante des Substrats 1 entlang geführt in Richtung des Flachleiters 4a, wobei das Licht 10 der Lichtquellen 8a, 8b, 8c in die Scheibe (I) eingekoppelt wird. Dadurch wird auch der Bereich der Scheibe (I) zwischen den Schaltflächen 3, 3a und damit der Bereich 6c des Lichtablenkmittels 6 mit Licht bestrahlt.

In einer alternativen Ausgestaltung der Erfindung kann auf dem Flachleiter 4 ein einzelne Lichtquelle 8 und ein Lichtwellenleiter, in den das Licht der Lichtquelle 8 eingekoppelt wird, angeordnet sein. Im Bereich des Lichtwellenleiters wird der Flachleiter 4 an der Seitenkante des Substrats 1 entlang geführt. Durch den Lichtwellenleiter kann ein größerer Bereich der Scheibe (I) mit Licht bestrahlt werden als von einer einzelnen Lichtquelle.

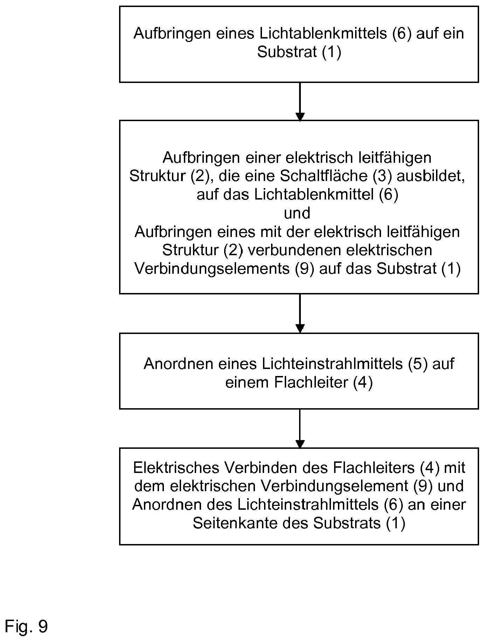

Fig. 9 zeigt ein Flussdiagramm eines Ausführungsbeispiels des erfindungsgemäßen Verfahrens zur Herstellung einer Scheibe (I) mit beleuchteter Schaltfläche als Einscheiben-Sicherheitsglas.

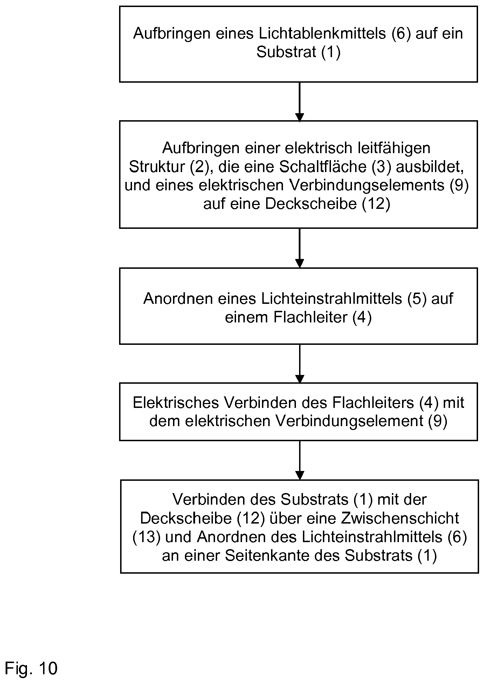

Fig. 10 zeigt ein Flussdiagramm eines Ausführungsbeispiels des erfindungsgemäßen Verfahrens zur Herstellung einer Scheibe (I) mit beleuchteter Schaltfläche als Verbund-Sicherheitsglas. In dem Ausführungsbeispiel wird das Lichtablenkmittel 6 auf dem Substrat 1 angeordnet. Die elektrisch leitfähige Struktur 2 und das elektrische Verbindungselement 9 werden auf der Deckscheibe 12 angeordnet. Die Positionierung des Lichtablenkmittels 6 und der elektrisch leitfähige Struktur 2 ist so zu wählen, dass nach dem Verbinden von Substrat 1 und Deckscheibe 12 die Fläche, die aus der Projektion des Lichtablenkmittels 6 auf die Ebene der Schaltfläche 3 hervorgeht, innerhalb der Schaltfläche 3 angeordnet ist und / oder die Schaltfläche 3 fortlaufend oder unterbrochen umrandet.

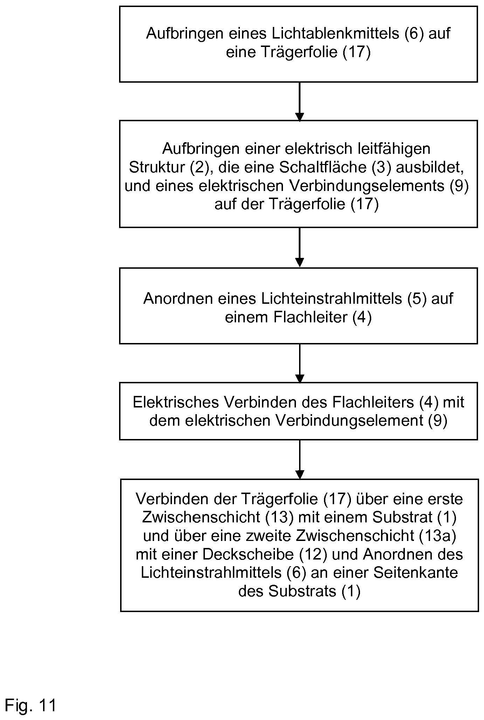

Fig. 11 zeigt ein Flussdiagramm eines Ausführungsbeispiels des erfindungsgemäßen Verfahrens zur Herstellung einer Scheibe (I) mit beleuchteter Schaltfläche als Verbund-Sicherheitsglas, wobei das Lichtablenkmittel 6, die elektrisch leitfähige Struktur 2 und das elektrische Verbindungselement 9 auf einer Trägerfolie 17 angeordnet werden.

Bei allen angefertigten Testproben wurde die Position der Schaltfläche 3 bei Dunkelheit durch über die Seitenkante des Substrats 1 in die Scheibe (I) eingekoppeltes und am Lichtablenkmittel 6 gestreutes Licht deutlich und eindeutig gekennzeichnet. Es war für den Fachmann unerwartet und überraschend, dass auf einfache und zuverlässige Weise eine Markierung der Schaltfläche 3 bereitgestellt werden kann.

### Bezugszeichenliste:

- (I): erfindungsgemäße Scheibe mit beleuchteter Schaltfläche

- (1): transparentes Substrat
- (2): elektrisch leitfähige Struktur
- (2a): elektrisch leitfähige Struktur
- (3): Schaltfläche
- (3a): Schaltfläche
- (4): Flachleiter
- (4a): Flachleiter
- (5): Lichteinstrahlmittel
- (6): Lichtablenkmittel
- (6a): Bereich des Lichtablenkmittels 6
- (6b): Bereich des Lichtablenkmittels 6
- (6c): Bereich des Lichtablenkmittels 6
- (8): Lichtquelle (LED)
- (8a): Lichtquelle (LED)
- (8b): Lichtquelle (LED)
- (8c): Lichtquelle (LED)
- (8d): Lichtquelle (LED)
- (9): elektrisches Verbindungselement
- (9a): elektrisches Verbindungselement
- (10): in die Scheibe (I) eingekoppeltes Licht
- (11): am Lichtablenkmittel 6 gestreutes Licht
- (12): Deckscheibe
- (13): Zwischenschicht
- (13a): Zwischenschicht
- (15): Rahmenelement
- (16): Reflektor
- (17): Trägerfolie
- (18): Schaltfeld

- A-A': Schnittlinie

## Patentansprüche

1. Scheibe (I) mit beleuchteter Schaltfläche, mindestens umfassend:
- ein transparentes Substrat (1),
- eine elektrisch leitfähige Struktur (2), die eine Schaltfläche (3) ausbildet,
- einen Flachleiter (4), der über ein elektrisches Verbindungselement (9) mit der elektrisch leitfähigen Struktur (2) elektrisch verbunden ist,
- ein Lichteinstrahlmittel (5), das zumindest eine Lichtquelle (8) umfasst und auf dem Flachleiter (4) und an einer Seitenkante des Substrats (1) angeordnet ist, wobei Licht (10) von der Seitenkante des Substrats (1) in die Scheibe (I) eingekoppelt wird,
- ein Lichtablenkmittel (6), das in dem vom Licht (10) des Lichteinstrahlmittels (5) bestrahlten Bereich der Scheibe (I) angeordnet ist, wobei die Fläche, die aus einer Projektion des Lichtablenkmittels (6) auf die Ebene der Schaltfläche (3) hervorgeht, innerhalb der Schaltfläche (3) angeordnet ist und / oder die Schaltfläche (3) fortlaufend oder unterbrochen umrandet und wobei das Lichtablenkmittel (6) Strukturen zur Lichtstreuung umfasst.

2. Scheibe (I) nach Anspruch 1, wobei das Lichtablenkmittel (6) Partikel, Punktraster, Aufkleber, Anlagerungen, Einkerbungen, Einritzungen, Strichraster, Aufdrucke und / oder Siebdrucke umfasst.

3. Scheibe (I) nach Anspruch 1 oder 2, wobei das Substrat (1) über mindestens eine Zwischenschicht (13) mit einer Deckscheibe (12) verbunden ist und die Zwischenschicht (13) bevorzugt zumindest Polyvinylbutyral (PVB) und / oder Ethylenvinylacetat (EVA) enthält.

4. Scheibe (I) nach einem der Ansprüche 1 bis 3, wobei die elektrisch leitfähige Struktur (2) und das Lichtablenkmittel (6) auf der gleichen oder auf einander gegenüberliegenden Oberflächen des Substrats (1) angeordnet sind.

5. Scheibe (I) nach Anspruch 3, wobei die elektrisch leitfähige Struktur (2) und das Lichtablenkmittel (6) auf der gleichen oder auf einander gegenüberliegenden Oberflächen der Deckscheibe (12) angeordnet sind.

6. Scheibe (I) nach Anspruch 3, wobei die elektrisch leitfähige Struktur (2) auf einer Oberfläche des Substrats (1) angeordnet ist und das Lichtablenkmittel (6) auf einer Oberfläche der Deckscheibe (12) angeordnet ist.

7. Scheibe (I) nach Anspruch 3, wobei die elektrisch leitfähige Struktur (2) auf einer Oberfläche der Deckscheibe (12) angeordnet ist und das Lichtablenkmittel (6) auf einer Oberfläche des Substrats (1) angeordnet ist.

8. Scheibe (I) nach Anspruch 3, wobei die elektrisch leitfähige Struktur (2) und / oder das Lichtablenkmittel (6) auf einer Trägerfolie (17) zwischen einer ersten Zwischenschicht (13) und einer zweiten Zwischenschicht (13a) angeordnet ist.

9. Scheibe (I) nach Anspruch 8, wobei die Trägerfolie (17) zumindest ein Polyester und / oder ein Polyimid, bevorzugt ein thermoplastisches Polyester, besonders bevorzugt Polyethylennaphthalat oder Polyethylenterephthalat enthält und bevorzugt eine Dicke von 10 µm bis 1 mm, besonders bevorzugt von 30 µm bis 200 µm aufweist.

10. Scheibe (I) nach einem der Ansprüche 1 bis 9, wobei der Flächeninhalt der Fläche, die aus einer Projektion des Lichtablenkmittels (6) auf die Ebene der Schaltfläche (3) hervorgeht, von 5 % bis 300 %, bevorzugt von 10 % bis 200 % des Flächeninhalts der Schaltfläche (3) beträgt.

11. Scheibe (I) nach einem der Ansprüche 1 bis 10, wobei das Lichteinstrahlmittel (5) einen Reflektor (16) und / oder einen Lichtwellenleiter umfasst.

12. Verfahren zur Herstellung einer Scheibe (I) mit beleuchteter Schaltfläche, wobei zumindest
(a) eine elektrisch leitfähige Struktur (2), die eine Schaltfläche (3) ausbildet, ein mit der elektrisch leitfähigen Struktur (2) verbundenes elektrisches Verbindungselement (9) und ein Lichtablenkmittel (6) auf ein transparentes Substrat (1) aufgebracht werden, und
(b) ein Lichteinstrahlmittel (5) auf einem Flachleiter (4) angeordnet wird und der Flachleiter (4) mit dem elektrischen Verbindungselement (9) elektrisch verbunden wird, wobei das Lichteinstrahlmittel (5) an einer Seitenkante des Substrats (1) angeordnet wird.

13. Verfahren zur Herstellung einer Scheibe (I) mit beleuchteter Schaltfläche, wobei zumindest
(a) eine elektrisch leitfähige Struktur (2), die eine Schaltfläche (3) ausbildet, und ein mit der elektrisch leitfähigen Struktur (2) verbundenes elektrisches Verbindungselement (9) auf ein transparentes Substrat (1) oder auf eine Deckscheibe (12) aufgebracht werden und ein Lichtablenkmittel (6) auf das transparente Substrat (1) oder auf die Deckscheibe (12) aufgebracht wird,
(b) ein Lichteinstrahlmittel (5) auf einem Flachleiter (4) angeordnet wird und der Flachleiter (4) mit dem elektrischen Verbindungselement (9) elektrisch verbunden wird und
(c) das Substrat (1) mit der Deckscheibe (12) über mindestens eine Zwischenschicht (13) unter Einwirkung von Hitze, Vakuum und / oder Druck verbunden wird, wobei das Lichteinstrahlmittel (6) an einer Seitenkante des Substrats (1) angeordnet wird.

14. Verfahren zur Herstellung einer Scheibe (I) mit beleuchteter Schaltfläche, wobei zumindest
(a) eine elektrisch leitfähige Struktur (2), die eine Schaltfläche (3) ausbildet, ein mit der elektrisch leitfähigen Struktur (2) verbundenes elektrisches Verbindungselement (9) und ein Lichtablenkmittel (6) auf eine Trägerfolie (17) aufgebracht werden,
(b) ein Lichteinstrahlmittel (5) auf einem Flachleiter (4) angeordnet wird und der Flachleiter (4) mit dem elektrischen Verbindungselement (9) elektrisch verbunden wird und
(c) die Trägerfolie (17) über eine erste Zwischenschicht (13) mit einem Substrat (1) und über eine zweite Zwischenschicht (13a) mit einer Deckscheibe (12) unter Einwirkung von Hitze, Vakuum und / oder Druck verbunden wird, wobei das Lichteinstrahlmittel (6) an einer Seitenkante des Substrats (1) abgeordnet wird.

15. Verfahren nach einem der Ansprüche 12 bis 14, wobei der Flachleiter (4) mit dem elektrischen Verbindungselement (9) durch Löten, Klemmen oder mittels eines elektrisch leitfähigen Klebstoffs elektrisch verbunden wird.

16. Verwendung einer Scheibe (I) mit beleuchteter Schaltfläche gemäß einem der Ansprüche 1 bis 11 als funktionales und / oder dekoratives Einzelstück und / oder als Einbauteil in Möbeln und Geräten, insbesondere elektronischen Geräten mit Kühl- oder Heizfunktion, zur Verglasung von Gebäuden, insbesondere im Zugangs- oder Fensterbereich, oder zur Verglasung in einem Fahrzeug für den Verkehr auf dem Lande, in der Luft oder zu Wasser, insbesondere in Kraftfahrzeugen, Bussen, Straßenbahnen, U-Bahnen und Zügen zur Personenbeförderung und für den öffentlichen Nah- und Fernverkehr, beispielsweise als Fahrzeugtür.

## Claims

1. Pane (I) having an illuminated switch surface, comprising at least:
- a transparent substrate (1),
- an electrically conductive structure (2), which forms a switch surface (3),
- a flat conductor (4), which is electrically connected to the electrically conductive structure (2) via an electrical connecting element (9),
- a light irradiation means (5), which comprises at least one light source (8) and is arranged on the flat conductor (4) and on a lateral edge of the substrate (1), wherein light (10) is coupled into the pane (I) from the lateral edge of the substrate (1),
- a light deflection means (6), which is arranged in the region of the pane (I) irradiated by the light (10) of the light irradiation means (5), wherein the area that results from a projection of the light deflection means (6) onto the plane of the switch surface (3) is arranged within the switch surface (3) and / or borders the switch surface (3) continuously or interruptedly and wherein the light deflection means (6) comprises structures for light scattering.

2. Pane (I) according to claim 1, wherein the light deflection means (6) comprises particles, point grids, stickers, deposits, indentations, scratches, line grids, imprints, and / or silkscreen prints.

3. Pane (I) according to claim 1 or 2, wherein the substrate (1) is connected to a cover pane (12) by at least one intermediate layer (13) and the intermediate layer (13) preferably contains at least polyvinyl butyral (PVB) and / or ethylene vinyl acetate (EVA).

4. Pane (I) according to one of claims 1 through 3, wherein the electrically conductive structure (2) and the light deflection means (6) are arranged on the same surface or on surfaces of the substrate (1) opposite one another.

5. Pane (I) according to claim 3, wherein the electrically conductive structure (2) and the light deflection means (6) are arranged on the same surface or on surfaces of the cover pane (12) opposite one another.

6. Pane (I) according to claim 3, wherein the electrically conductive structure (2) is arranged on a surface of the substrate (1) and the light deflection means (6) is arranged on a surface of the cover pane (12).

7. Pane (I) according to claim 3, wherein the electrically conductive structure (2) is arranged on a surface of the cover pane (12) and the light deflection means (6) is arranged on a surface of the substrate (1).

8. Pane (I) according to claim 3, wherein the electrically conductive structure (2) and / or the light deflection means (6) is arranged on a carrier film (17) between a first intermediate layer (13) and a second intermediate layer (13a).

9. Pane (I) according to claim 8, wherein the carrier film (17) contains at least one polyester and / or one polyimide, preferably a thermoplastic polyester, particularly preferably polyethylene naphthalate, or polyethylene terephthalate and preferably has a thickness from 10 µm to 1 mm, particularly preferably from 30 µm to 200 µm.

10. Pane (I) according to one of claims 1 through 9, wherein the surface area of the surface that results from a projection of the light deflection means (6) onto the plane of the switch surface (3) is from 5% to 300%, preferably from 10% to 200% of the surface area of the switch surface (3).

11. Pane (I) according to one of claims 1 through 10, wherein the light irradiation means comprises (5) a reflector (16) and / or an optical waveguide.

12. Method for producing a pane (I) having an illuminated switch surface, wherein at least
a) an electrically conductive structure (2), which forms a switch surface (3), an electrical connecting element (9) connected to the electrically conductive structure (2), and a light deflection means (6) are applied on a transparent substrate (1), and
b) a light irradiation means (5) is arranged on a flat conductor (4) and the flat conductor (4) is electrically connected to the electrical connecting element (9), wherein the light irradiation means (5) is arranged on a lateral edge of the substrate (1).

13. Method for producing a pane (I) having an illuminated switch surface, wherein at least
a) an electrically conductive structure (2), which forms a switch surface (3), and an electrical connecting element (9) connected to the electrically conductive structure (2) are applied on a transparent substrate (1) or on a cover pane (12) and a light deflection means (6) is applied on the transparent substrate (1) or on the cover pane (12),
b) a light irradiation means (5) is arranged on a flat conductor (4) and the flat conductor (4) is electrically connected to the electrical connecting element (9), and
c) the substrate (1) is bonded to the cover pane (12) by at least one intermediate layer (13) under the action of heat, vacuum, and / or pressure, wherein the light irradiation means (6) is arranged on a lateral edge of the substrate (1).

14. Method for producing a pane (I) having an illuminated switch surface, wherein at least
a) an electrically conductive structure (2), which forms a switch surface (3), an electrical connecting element (9) connected to the electrically conductive structure (2), and a light deflection means (6) are applied on a carrier film (17),
b) a light irradiation means (5) is arranged on a flat conductor (4) and the flat conductor (4) is electrically connected to the electrical connecting element (9), and
c) the carrier film (17) is bonded to a substrate (1) by a first intermediate layer (13) and to a cover pane (12) by a second intermediate layer (13a) under the action of heat, vacuum, and / or pressure, wherein the light irradiation means (6) is arranged on a lateral edge of the substrate (1).

15. Method according to one of claims 12 through 14, wherein the flat conductor (4) is electrically connected to the electrical connecting element (9) by soldering, clamping, or by means of an electrically conductive adhesive.

16. Use of a pane (I) having an illuminated switch surface according to one of claims 1 through 11 as a functional and / or decorative individual piece and / or as a built-in component in furniture and devices, in particular electronic devices with a cooling or heating function, for glazing of buildings, in particular in the access or window area, or for glazing in a motor vehicle for travel on land, in the air, or on water, in particular in automobiles, buses, streetcars, subways, and trains for passenger service and for public short and long distance travel, for example, as a motor vehicle door.

## Revendications

1. Vitre (I) avec une zone de commande éclairée, comprenant au moins :
- un support transparent (1),
- une structure conductrice d'électricité (2), qui forme une zone de commande (3),
- un conducteur plat (4) qui est reliée électriquement à la structure conductrice d'électricité (2) par un élément de raccordement électrique (9),
- un moyen d'irradiation lumineuse (5), qui comprend au moins une source de lumière (8) et qui est disposé sur le conducteur plat (4) et le bord latéral du substrat (1) où de la lumière (10) en provenance du bord latéral du substrat (1) est couplée dans la vitre (I),
- un moyen de déviation de la lumière (6), qui est disposé dans la zone de la vitre (I) irradiée par de la lumière (10) du moyen d'irradiation lumineuse (5), où la surface, qui résulte d'une projection du moyen de déviation de la lumière (6) au niveau de la zone de commande (3) est disposé à l'intérieur de la zone de commande (3) et / ou entoure la zone de commande (3) de manière continue ou discontinue et où le moyen de déviation de la lumière (6) comprend des structures pour la diffusion de la lumière.

2. Vitre (I) selon la revendication 1, où le moyen de déviation de la lumière (6) comprend des particules, des matrices de points, des autocollants, des dépôts, des encoches, des entailles, des trames réticulées, des surimpressions et/ou des sérigraphies.

3. Vitre (I) selon la revendication 1 ou 2, où le substrat (1) est relié à une plaque de recouvrement (12) par au moins une couche intermédiaire (13) et la couche intermédiaire (13) contient de préférence au moins du polyvinylbutyral (PVB) et / ou de l'éthylène-acétate de vinyle (EVA).

4. Vitre (I) selon l'une des revendications 1 à 3, où la structure conductrice d'électricité (2) et le moyen de déviation de la lumière (6) sont disposés soit sur une même face soit de part et d'autre sur les surfaces opposées du substrat (1).

5. Vitre (I) selon la revendication 3, où la structure conductrice d'électricité (2) et le moyen de déviation de la lumière (6) sont disposés soit sur une même face soit de part et d'autre sur les surfaces opposées de la plaque de recouvrement (12).

6. Vitre (I) selon la revendication 3, où la structure conductrice d'électricité (2) est disposée sur une surface du substrat (1) et le moyen de déviation de la lumière (6) est disposé sur une surface de la plaque de recouvrement (12).

7. Vitre (I) selon la revendication 3, où la structure conductrice d'électricité (2) est disposée sur une surface de la plaque de recouvrement (12) et le moyen de déviation de la lumière (6) est disposé sur une surface du substrat (1).

8. Vitre (I) selon la revendication 3, où la structure conductrice d'électricité (2) et/ou le moyen de déviation de la lumière (6) sont disposés sur une feuille de support (17) entre une première couche intermédiaire (13) et une deuxième couche intermédiaire (13a).

9. Vitre (I) selon la revendication 8, où la feuille de support (17) contient au moins un polyester et/ou un polyester thermoplastique, de préférence un polyimide, de manière particulièrement préférée du naphthalate de polyéthylène ou du téréphtalate polyéthylène et de préférence présente une épaisseur de 10 µm à 1 mm, de manière particulièrement préférée de 30 µm à 200 µm.

10. Vitre (I) selon l'une des revendications 1 à 9, où la superficie de la surface, résultant d'une projection du moyen de déviation de la lumière (6) au niveau de la zone de commande (3), est de 5 à 300 %, de préférence de 10 % à 200 % de la superficie de la zone de commande (3).

11. Vitre (I) selon l'une des revendications 1 à 10, où le moyen d'irradiation lumineuse (5) comprend un réflecteur (16) et/ou une fibre optique.

12. Procédé de fabrication d'une vitre (I) avec une zone de commande lumineuse, où au moins
(a) une structure conductrice d'électricité (2), qui forme une zone de commande (3), un élément de raccordement électrique (9) relié à la structure conductrice d'électricité (2) et un moyen de déviation de la lumière (6) sont appliqués sur un substrat transparent (1) et
(b) un moyen d'irradiation de lumière (5) est disposé sur un conducteur plat (4) et le conducteur plat (4) est relié à l'élément de raccordement électrique (9) où le moyen d'irradiation lumineuse (5) est disposé sur un bord latéral du substrat (1).

13. Procédé de fabrication d'une vitre (I) avec une zone de commande lumineuse, où au moins
(a) une structure conductrice d'électricité (2), qui forme une zone de commande (3) et un élément de raccordement électrique (9) associé à la structure conductrice d'électricité (2) sont appliqués sur un substrat transparent (1) ou une plaque de couverture (12) et un moyen de déviation de la lumière (6) sont appliqués sur le substrat transparent (1) ou sur la plaque de couverture (12),
(b) un moyen d'irradiation de lumière (5) est disposé sur un conducteur plat (4) et le conducteur plat (4) est reliée électriquement à l'élément de raccordement électrique (9), et
(c) le substrat (1) est relié avec la plaque de recouvrement (12) par au moins une couche intermédiaire (13) sous l'action d'un apport de chaleur, d'un vide et/ou de la pression, où le moyen d'irradiation de la lumière (6) est disposé sur un bord latéral du substrat (1).

14. Procédé de fabrication d'une vitre (I) avec une zone de commande lumineuse, où au moins
(a) une structure conductrice d'électricité (2), qui forme une zone de commande (3) et un élément de raccordement électrique (9) associé à la structure conductrice d'électricité (2) et un moyen de déviation de la lumière (6)sont appliqués sur une feuille de support (17),
(b) un moyen d'irradiation lumineuse (5) est disposé sur un conducteur plat (4) et le conducteur plat (4) est relié électriquement à l'élément de raccordement électrique (9) et
(c) la feuille de support (17) est reliée par une première couche intermédiaire (13) avec un substrat (1) et une seconde couche intermédiaire (13a) avec une plaque de recouvrement (12) sous l'action d'un apport de chaleur, d'un vide et/ou de la pression, où le moyen d'irradiation de la lumière (6) est disposé sur un bord latéral du substrat (1).

15. Procédé selon l'une des revendications 12 à 14, où le conducteur plat (4) est relié électriquement à l'élément de raccordement électrique (9), par brasage, serrage, ou au moyen d'un adhésif conducteur d'électricité.

16. Utilisation d'une vitre (I) avec une zone de commande lumineuse selon l'une des revendications 1 à 11 comme pièce fonctionnelle et/ou décorative dans le mobilier, les appareils et le bâtiment, en particulier les appareils électroniques avec fonction de refroidissement ou de chauffage, dans le vitrage des bâtiments, en particulier dans les zones d'accès ou des fenêtres, ou pour le vitrage dans un véhicule pour le transport sur la terre, dans l'air ou dans l'eau, en particulier dans les véhicules automobiles, les autobus, les tramways, les métros et les trains pour le transport de passagers et pour les services de transport en commun locaux et de longue distance, tels que la porte d'un véhicule.
